# EUROPEAN PATENT APPLICATION

(11) **EP 4 763 392 A1**
(43) Date of publication of application: **24.06.2026**
(21) Application number: 24865863.5
(22) Date of filing: 12.09.2024
(51) Int. Cl.: B23K 1/005, B23K 26/03, B23K 31/12, B23K 3/06, B23K 26/042, H05K 3/34, B23K 101/36

(54) **LASER SOLDERING APPARATUS HAVING ADJUSTABLE SOLDERING POSITION AND SOLDERING METHOD COMPRISING SAME**

(30) Priority: 12.09.2023 KR 20230120811; 12.08.2024 KR 20240107339
(71) Applicant: Laservall Technology Co., Ltd, Suwon-si, Gyeonggi-do 16648 (KR)
(72) Inventor: CHOI, Byung-Chan, Gwangmyeong-si Gyeonggi-do 14230 (KR)
(74) Representative: Isarpatent
(86) International application number: PCT/KR2024/013876
(87) International publication number: WO 2025/058424

(57) **Abstract**

The present invention relates to a laser soldering apparatus with an adjustable soldering position and a method thereof.

The apparatus comprises: a controller; a fixing block coupled to a circuit board, the fixing block having a plurality of fixing pins extending in one direction and a plurality of insertion holes into which the fixing pins are inserted; an image module coupled to the circuit board through the fixing block; a solder unit that performs soldering at predetermined time intervals under the control of the controller, the solder unit having at least one nozzle unit configured to accommodate solder balls, to discharge molten solder, and to perform soldering by irradiation of a laser beam; and a monitoring unit disposed at one side of the solder unit to monitor a distribution range of solder balls supplied by irradiation of the laser beam.

The supply position of the solder balls discharged from the solder unit into the fixing-pin and insertion-hole region is adjusted according to monitoring results of the monitoring unit, thereby enabling precise and reliable soldering even under external impact or vibration.

Accordingly, the present invention provides a laser soldering apparatus with an adjustable soldering position and a corresponding method that significantly improve bonding reliability and prevent damage to the soldered joint area.

## Description

### FIELD OF DISCLOSURE

The present invention relates to a laser soldering apparatus having an adjustable soldering position and a soldering method including the same, and more particularly, to a laser soldering apparatus having an adjustable soldering position which enables adjustment of the soldering position through a plurality of soldering processes, and to a soldering method including the same.

### BACKGROUND

In recent years, the miniaturization and thinning of electronic devices have been rapidly progressing. In addition, miniaturization and thinning are also required for electronic components such as semiconductor devices mounted in such electronic devices. Furthermore, as the electronic components become highly integrated, the number of connection terminals has been increasing.

As a method for mounting electronic components that meets such requirements, a mounting method has recently been applied in which solder balls are surface-mounted as external connection terminals on a mounting substrate such as a printed circuit board (PCB), for example, by employing flip chip mounting. In this mounting method, solder balls are mounted on electrodes provided on the substrate of an electronic component and then directly bonded to the electrodes of the mounting substrate.

Therefore, in the case where a surface-mounting method utilizing solder balls is applied, it is generally used that, after positioning the solder balls on the electrodes of the substrate on which the solder balls are to be mounted, the solder balls are heated and melted to be bonded to the electrodes.

Among such soldering methods, a method of irradiating a laser beam onto the surface of the solder balls to heat and melt the solder balls for high-precision and high-quality soldering has recently been applied. However, external impact or external vibration may cause safety accidents such as breakage of the bonded portions.

### [PRIOR DOCUMENT(S)]

### [Patent Documents]

(Patent Document 0001) Korean Patent Publication No. 2013-0064392
(Patent Document 0002) Korean Patent Publication No. 2015-0028511

### DISCLOSURE OF THE INVENTION

### Technical Problems

The problem to be solved by the present invention is to provide a laser soldering apparatus having an adjustable soldering position and a soldering method including the same, which can significantly improve bonding reliability by preventing breakage of soldered portions even under external impact, by allowing the soldering process to be performed by injecting solder provided to the soldering position multiple times in a specific manner in order to fix an image module onto a circuit board through soldering.

In addition, the present invention provides a laser soldering apparatus having an adjustable soldering position and a soldering method including the same, in which an image module is soldered and fixed onto a circuit board, and the soldering position is adjustable at a predetermined angle so that soldering can be performed accordingly, thereby improving the rigidity of the soldered portion and preventing damage to the apparatus caused by reflection of the laser beam.

### SOLUTION TO PROBLEMS

To achieve the above-described objectives, a laser soldering apparatus having an adjustable soldering position according to the present invention comprises:
a controller;
a fixing block coupled to a circuit board, the fixing block having a plurality of fixing pins extending in one direction and a plurality of insertion holes into which the fixing pins are inserted;
an image module coupled to the circuit board through the fixing block;
a laser generation unit configured to generate a laser beam;
a soldering unit which is operable to move under the control of the controller to perform multiple soldering operations on the insertion hole portions into which the fixing pins are inserted at predetermined time intervals, the soldering unit being provided with at least one nozzle unit configured to receive solder and discharge the melted solder; and
a monitoring unit disposed on one side of the soldering unit, configured to monitor a distribution range of the solder supplied by irradiation of the laser beam.

In the apparatus, a solder injection position at which the solder supplied from the soldering unit is injected into the fixing pin and insertion hole portions may be adjusted according to the monitoring result obtained by the monitoring unit, so that the soldering position can be controlled.

In one embodiment of the present invention,
the solder comprises solder balls, and the laser beam is irradiated onto the solder balls so that the solder balls are melted and discharged.

In one embodiment of the present invention, the nozzle unit is provided with a sleeve that is heated by the laser, and the solder may be melted by the heat generated from the sleeve heated by the laser.

In one embodiment of the present invention, the solder balls may be configured to be supplied to the fixing pin and insertion hole portions at predetermined time intervals, in a range of at least three to seven times.

In one embodiment of the present invention, the solder balls may be supplied and soldered starting from a position where the outer circumferential surface of the fixing pin and the inner circumferential surface of the insertion hole are in contact or in a mutually closest proximity.

In one embodiment of the present invention, the soldering unit may include a structure in which the solder balls are discharged while the soldering unit is inclined at a predetermined angle with respect to the fixing pins and insertion holes.

In one embodiment of the present invention, the laser beam may be controlled so that the irradiation onto the melted and discharged solder balls is maintained for a predetermined period of time.

In one embodiment of the present invention, the fixing holes of the fixing block may include a structure in which three holes are radially arranged at equal angles with respect to the center point of the fixing block.

In one embodiment of the present invention, one side of the soldering unit may include a gas supply unit configured to supply an inert gas to the discharged solder balls.

In one embodiment of the present invention, the solder balls supplied to the nozzle unit may include a structure in which the size of the solder balls is controlled by the controller according to the distribution range of the solder balls detected during the soldering process.

In one embodiment of the present invention, the apparatus may further include a beam adjusting unit configured to adjust the irradiation position of the laser beam, the beam adjusting unit including:
a beam focusing unit configured to adjust the focal position of the laser beam; and
a laser irradiation unit configured to acquire information regarding the position and alignment state at which the laser, adjusted by the beam focusing unit, is to be irradiated, and to irradiate the laser beam onto a workpiece based on the acquired information.

In one embodiment of the present invention, the soldering unit may further include at least one beam conversion device for adjusting the output area of the laser beam.

In one embodiment of the present invention, the laser beam emitted from the soldering unit may be a laser beam including a plurality of wavelengths, and each wavelength may be delivered to heterogeneous or homogeneous workpieces to perform bonding.

In one embodiment of the present invention, the transmission of the laser may include an optical fiber laser that transmits the laser to the head portion through an optical fiber.

In one embodiment of the present invention, the core of the optical fiber may include a structure formed in a circular or polygonal shape, allowing the laser irradiation position to be aligned.

In one embodiment of the present invention, the fixing block may be prebonded and transported by a transfer unit so that the laser irradiation position and the solder discharge position can be aligned.

In one embodiment of the present invention, the soldering unit may further include an imaging unit configured to perform image processing on a workpiece such as the soldering position and solder distribution range.

In one embodiment of the present invention, the laser may be irradiated in the form of a flat-top output, in which the laser irradiation position is aligned.

Furthermore, in a laser soldering apparatus having an adjustable soldering position according to the present invention, the apparatus comprises:
a controller;
an image module coupled to a circuit board;
a first fixing block formed on one side of the image module and having a plurality of fixing pins extending in one direction; and
a second fixing block provided to fix the image module onto the circuit board, the second fixing block being in surface contact with the first fixing block of the image module and having a plurality of insertion holes into which the fixing pins are inserted;
a laser generation unit configured to generate a laser beam;
a soldering unit which is operable to move under the control of the controller so as to perform multiple soldering operations on the insertion hole portions into which the fixing pins are inserted at predetermined time intervals, the soldering unit including at least one nozzle unit configured to receive solder and discharge the melted solder; and
a monitoring unit disposed on one side of the soldering unit and configured to monitor a distribution range of the solder balls supplied by irradiation of the laser beam,
wherein an injection position of the solder balls injected from the soldering unit into the fixing pin and insertion hole portions may be adjusted according to the monitoring result obtained by the monitoring unit.

Furthermore, in a laser soldering apparatus having an adjustable soldering position according to another embodiment of the present invention, the apparatus comprises:
a controller;
an image module coupled to a circuit board having insertion holes, the image module having a plurality of fixing pins formed to extend in one direction so as to be inserted into the insertion holes;
a laser generation unit configured to generate a laser beam;
a soldering unit which is operable to move under the control of the controller so as to perform multiple soldering operations on the insertion hole portions into which the fixing pins are inserted at predetermined time intervals, the soldering unit including at least one nozzle unit configured to receive solder and discharge the melted solder; and
a monitoring unit disposed on one side of the soldering unit and configured to monitor a distribution range of the solder balls supplied by irradiation of the laser beam,
wherein an injection position of the solder balls injected from the soldering unit into the fixing pin and insertion hole portions may be adjusted according to the monitoring result obtained by the monitoring unit.

Meanwhile, the present invention also provides a soldering method using the above-described laser soldering apparatus having an adjustable soldering position, the method comprising:
a placing step of placing an image module on which a circuit board is mounted;
a fixing step of positioning fixing pins of the image module into insertion holes of a fixing block;
a monitoring step of recognizing X, Y, and Z coordinates of the center points of the fixing pins and monitoring the positions of the center points of the fixing pins within the insertion holes; and
an adjusting step of aligning a nozzle unit of a soldering unit that supplies solder balls according to the result of the monitoring.
a solder supplying step of continuously or intermittently supplying the solder balls to a nozzle unit at predetermined time intervals in order to perform multiple soldering operations on the insertion hole portions into which the fixing pins are inserted; and
a discharging step of irradiating the solder balls with a laser beam to melt the solder balls and injecting the solder balls into the fixing pin and insertion hole portions, may be included.

In one embodiment of the present invention, in the discharging step in which the solder balls are discharged, the laser beam may be maintained so as to be irradiated for a predetermined period of time after the solder balls are discharged.

Here, in one embodiment of the present invention, the discharging step of the solder balls may include:
a first soldering process in which the solder balls are supplied to a position where the outer circumferential surface of the fixing pin and the inner circumferential surface of the insertion hole are in contact or in mutually closest proximity;
a second soldering process in which the solder balls are supplied in a shape that at least partially overlaps with the first soldering region; and
at least one third soldering process in which the solder balls are discharged at least partially onto the overlapping region.

In one embodiment of the present invention, after the second soldering process, a step may be included in which the soldering unit is adjusted at a predetermined angle according to Xe, Ye, and Z_{θ} coordinates of a three-dimensional shape of the overlapping region.

In one embodiment of the present invention, in the step of supplying the solder balls to the nozzle unit, a step may further be included in which the size of the supplied solder balls is selectively adjusted according to the distribution range of the solder balls detected during the soldering process.

In one embodiment of the present invention, in the second and third soldering processes, a post-heating process may be included in which the irradiation of the laser beam on the overlapping region is maintained for a predetermined period of time.

In one embodiment of the present invention, the step of supplying the solder balls to the nozzle unit may be performed within a range of at least two to seven times.

In one embodiment of the present invention, after the step of discharging the solder balls, with respect to the fixing pins and the insertion holes, the soldering unit may be disposed at a predetermined inclination angle (θ), and a step may be included in which Xe, Ye, and Z_{θ} coordinates of the center points of the fixing pins are recognized.

In one embodiment of the present invention, in the step of supplying the solder balls to the nozzle unit, an inert gas discharged from a gas supply unit formed on one side of the soldering unit may be supplied to the discharged solder balls.

In one embodiment of the present invention, the process of supplying the inert gas may be performed in synchronization with the irradiation process of the laser beam for melting the solder balls, and may be performed simultaneously or alternately with the laser irradiation process.

In one embodiment of the present invention, the post-heating process may include an alignment correction step of remelting the solder to set offsets in the X-axis direction, Y-axis direction, Z-axis direction, X-axis theta direction, Y-axis theta direction, and Z-axis theta direction according to the contraction amount of the solder, thereby correcting the alignment between the circuit board and the image module.

Specific details of other embodiments are included in the detailed description and the accompanying drawings.

### ADVANTAGEOUS EFFECTS of INVENTION

According to the laser soldering apparatus having an adjustable soldering position and the soldering method including the same of the present invention, by performing a soldering process in such a manner that solder balls provided to the soldering position are supplied multiple times in a specific manner in order to fix an image module onto a circuit board through soldering, it is possible to prevent breakage of soldered portions even under external impact and to significantly improve bonding reliability.

According to the laser soldering apparatus having an adjustable soldering position and the soldering method including the same of the present invention, the invention provides an effect in that the image module is soldered and fixed onto the circuit board while being adjustable at a predetermined angle with respect to the soldering position so that soldering can be performed accordingly, thereby improving the rigidity of the soldered portion and preventing damage to the apparatus caused by reflection of the laser beam.

The effects of the present invention are not limited to the effects described above, and other effects not mentioned herein will be clearly understood by those skilled in the art from the description of the claims.

### BRIEF DESCRIPTION OF THE DRAWINGS

FIG. 1 is a schematic configuration diagram of a laser soldering apparatus having an adjustable soldering position according to an embodiment of the present invention;
FIG. 2 is an exemplary diagram illustrating a soldering shape of the laser soldering apparatus according to an embodiment of the present invention;
FIGS. 3 and 4 are diagrams illustrating examples in which a soldering processing position is adjusted according to an embodiment of the present invention;
FIGS. 5 and 6 are diagrams illustrating states in which soldering is performed by the laser soldering apparatus according to an embodiment of the present invention;
FIGS. 7 to 9 are flowcharts illustrating soldering processes performed by the laser soldering apparatus according to an embodiment of the present invention;
FIG. 10 is a diagram illustrating a state in which preheating and heating are performed through a laser according to an embodiment of the present invention; and
FIG. 11 is a diagram illustrating a configuration of an optical fiber for transmitting a laser according to an embodiment of the present invention.

### DETAILED DESCRIPTION

Hereinafter, an embodiment of the present invention will be described in detail with reference to the accompanying drawings. In the drawings, reference numerals are assigned to components, and it should be noted that the same reference numerals denote the same components, even though they may appear in different drawings, as far as possible. In addition, in describing the embodiments of the present invention, detailed descriptions of well-known structures or functions will be omitted when it is determined that such detailed descriptions would obscure the understanding of the embodiments of the present invention.

In describing the components of the embodiment of the present invention, terms such as "first," "second," "A," "B," "(a)," and "(b)" may be used. These terms are merely used to distinguish one component from another, and such terms do not limit the nature, order, or sequence of the components. Unless otherwise defined, all terms used herein, including technical and scientific terms, have the same meanings as those commonly understood by one of ordinary skill in the art to which this invention pertains. Terms that are generally defined in dictionaries should be interpreted as having meanings consistent with their contextual use in the relevant technical field and should not be interpreted as having idealized or overly formal meanings unless expressly defined herein.

Through the soldering apparatus and method having an adjustable soldering position according to the embodiment of the present invention, laser processing operations such as bonding, welding, joining, and soldering of an image module onto a circuit board can be performed. In the following description, the laser soldering apparatus and method of the invention will be explained by way of example as performing a soldering process. That is, the laser processing apparatus may be employed as a soldering apparatus to perform only the soldering process. In such a case, the laser processing apparatus may be described as a soldering apparatus.

Furthermore, the soldering apparatus having an adjustable soldering position according to the embodiment of the present invention may be applied not only to various processes such as welding, soldering, bonding, and joining, but also to various materials on which each process is performed, including polymers, metals, dielectrics, semiconductors, and glass.

As described above, in the case of the conventional soldering structure of an image module, there has been a problem in bonding reliability, such as breakage of the bonded portion due to external shocks or vibrations resulting from environmental factors.

Accordingly, in the present invention, as described below, in order to fix an image module by soldering on a circuit board, solder is continuously supplied to the soldering position of the workpiece multiple times in a specific manner so that the soldering process proceeds, thereby preventing damage to the soldered portion in advance even under external impacts.

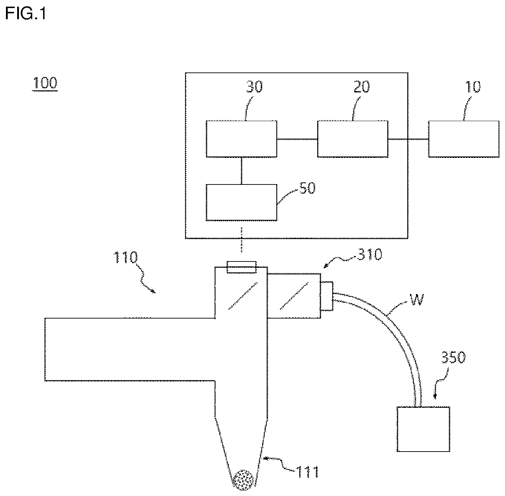

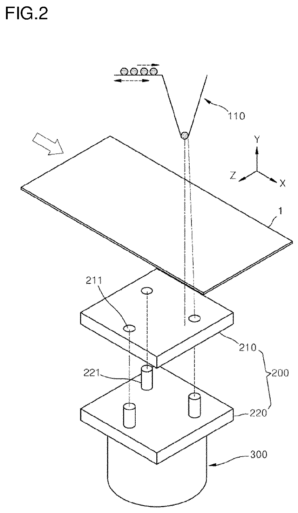

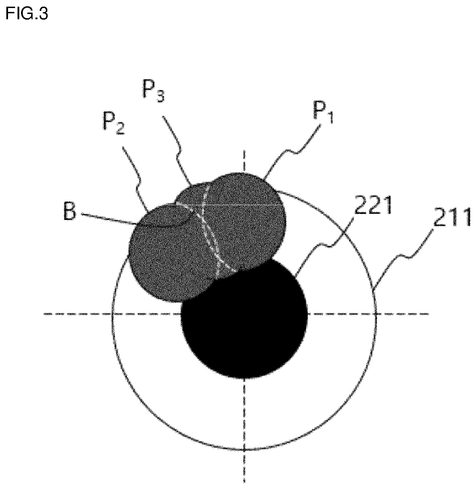

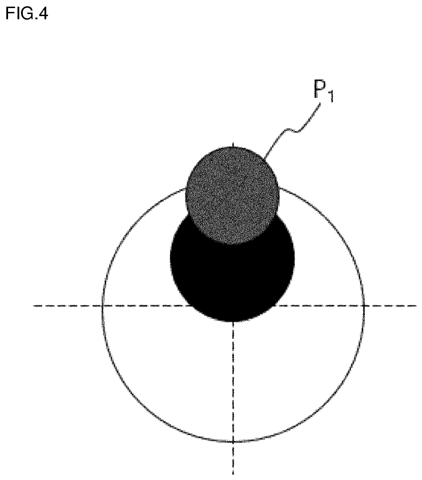

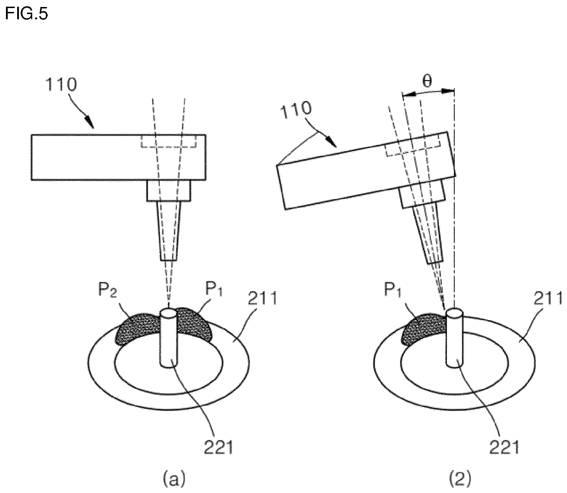

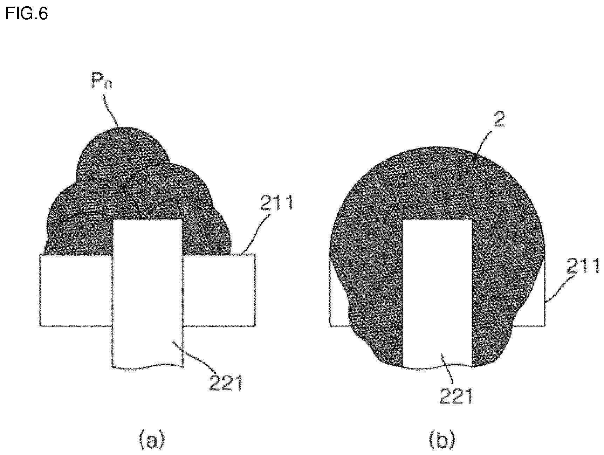

FIG. 1 is a schematic configuration diagram of a laser soldering apparatus having an adjustable soldering position according to an embodiment of the present invention; FIG. 2 is an exemplary diagram illustrating a soldering shape of the laser soldering apparatus according to an embodiment of the present invention; FIGS. 3 and 4 are diagrams illustrating examples in which a soldering processing position is adjusted according to an embodiment of the present invention; and FIGS. 5 and 6 are diagrams illustrating states in which soldering is performed by the laser soldering apparatus according to an embodiment of the present invention.

Referring to these drawings, a laser soldering apparatus (100) according to the present invention may include a controller (10); a fixing block (200) which is coupled to a circuit board (not shown) and has a plurality of fixing pins (221) extending in one direction and a plurality of insertion holes (211) into which the fixing pins (221) are inserted; an image module (300) coupled to the circuit board via the fixing block (200); a soldering unit (110) which is operable to move under the control of the controller (10) in order to perform multiple soldering operations at predetermined time intervals on the insertion hole portions into which the fixing pins (221) are inserted, the soldering unit (110) performing soldering by means of a laser beam and having a nozzle unit (111) configured to accommodate solder balls (S) irradiated with the laser beam; and a monitoring unit (350) disposed on one side of the soldering unit (110) to monitor the distribution range of the solder balls (S) supplied by irradiation of the laser beam-i.e., the solder bumps (2)-wherein an injection position of the solder balls (S) injected from the soldering unit (110) into the fixing pin (221) and insertion hole (211) portions may be adjusted according to the monitoring result obtained by the monitoring unit (350).

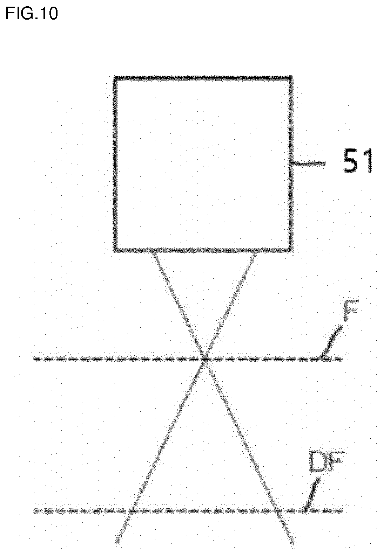

The laser soldering apparatus (100) may include a laser generation unit (20), a beam converter (30), and a beam adjustment unit (50). A laser emitted from the laser generation unit (20) may pass through the beam converter (30), during which the cross-sectional area of the laser beam may be adjusted. The adjusted cross-sectional area of the beam may correspond to the cross-sectional area of the laser that will be irradiated toward the soldering position. The laser that has passed through the beam converter (30) may be transmitted to a head portion (FIG. 10: 51) of the beam adjustment unit (50). The laser transmitted from the head portion (FIG. 10: 51) may melt solder balls (S), which are then discharged from the nozzle unit at predetermined time intervals that have been preset.

The laser transmitted from the head portion (FIG. 10: 51) may be delivered not only to the solder balls (S) disposed in the nozzle unit (111) but also, depending on the operator's selection, to the solder balls (S) arranged in the insertion holes that are formed to a predetermined size or greater.

In another embodiment, the nozzle unit (111) may be provided as a sleeve. The laser emitted from the laser generation unit (20) may be transmitted to the head portion (FIG. 10: 51) and irradiated onto the nozzle unit (111) to heat it. Solder supplied to the inside of the nozzle unit (111) may be melted by the heat emitted from the heated nozzle unit (111) so that soldering can be performed.

The beam adjustment unit (50) may include a beam focusing unit (not shown) for adjusting the focal position of the laser beam, and a laser irradiation unit (not shown) for irradiating the laser beam by acquiring information on the position and alignment state at which the laser adjusted by the beam focusing unit is to be irradiated. In some cases, the beam adjustment unit may further include a thermal distribution measuring unit (310), such as a pyrometer, for measuring the surface temperature or melting temperature of the soldering processing point. The monitoring unit (350) may be, for example, a dynamic focusing module or a camera module, but is not limited thereto.

The controller (10) may control the movement of the soldering unit (110) and the irradiation of the laser so that a soldering process can be performed at the soldering point of the image module (300). The transfer unit (30) may transport the image module

(300) coupled to the circuit board so as to accurately position the soldering location, that is, the portion between the fixing pins (221) and the insertion holes (211).

The laser soldering apparatus (100) may be adjusted so that the center point of the nozzle unit (111) is positionally aligned with the soldering point, where the solder (S) melted by the irradiation of the laser beam is discharged.

The fixing block (200) may be configured to allow the circuit board to be coupled thereto, or alternatively, the circuit board may be mounted on one side of the fixing block (200). In one example according to the present invention, the fixing block (200) may include a first fixing block (220) formed on one side of the image module (300) and having fixing pins (221) protruding upward, and a second fixing block (210) provided to fix the image module (300) on the circuit board, the second fixing block (210) being in surface contact with the first fixing block (220) of the image module (300) and having insertion holes (211) into which the fixing pins (221) are inserted. According to the present invention, the fixing pins (221) of the first fixing block (220) are formed to protrude a predetermined length from the uppermost ends of the insertion holes (211), so that the space between the fixing pins (221) and the insertion holes (211) is filled with solder, thereby enhancing the mutual bonding strength through soldering.

Specifically, the laser soldering apparatus (100) according to the present invention may be configured such that, before, during, or after the discharge of the supplied solder (S), the center point of the nozzle unit (111) is corrected to move to the soldering point where the solder (S) is discharged, based on the image acquired from the monitoring unit (350). At this time, the solder (S) may be supplied to the nozzle unit (111) of the soldering unit (110) intermittently or continuously at predetermined time intervals.

The movement of the center point of the nozzle unit (111) may be controlled by the controller (10). The controller (10) may determine the coordinates (x, y, z) of the position where the solder (S) is discharged, based on detection values input and measured from the monitoring unit (350). These coordinates may be adjusted so that the laser beam, having passed through the beam converter (30), is focused along the z-axis by a dynamic focusing module (not shown), and the x-axis and y-axis positions are aligned with the soldering position by a scan head (not shown). In the present invention, by adjusting the coordinate position (x, y, z) at which the solder (S) melted by the laser beam is discharged, an ideal soldering position can be achieved.

In some cases, such focal coordinates may be adjusted using a precision stage configured with at least three axes, and may include a tilt stage for adjusting the angle at which the laser beam is irradiated. Here, the tilt stage may include one or more of X-theta, Y-theta, and Z-theta axes.

The laser soldering apparatus (100) according to the present invention may discharge solder (S) toward a soldering point at predetermined time intervals so that continuous soldering can be performed. That is, as shown in FIGS. 3 and 4, the solder (S) melted by the laser beam may be discharged to the coordinate position (x, y, z) where the solder (S) is to be deposited, intermittently or continuously, at predetermined time intervals, in a range of approximately at least two to seven times. For example, the laser soldering apparatus (100) may sequentially discharge the melted solder (S) into a soldering position, that is, into the space between the fixing pin (211) and the insertion hole (211). At the soldering position, first soldering (P1), second soldering (P2), third soldering (P3), and nth soldering (Pn) may be performed at boundary regions (B) that are at least partially overlapped with one another.

Preferably, the first soldering (P1) of the solder (S) melted by the laser beam is preferably performed first at a location where the outer circumferential surface of the fixing pin (211) and the inner circumferential surface of the insertion hole (211) are in their closest proximity. At this time, depending on the size and shape of the solder bump (2) formed by the overlapping of the solder (S) melted by the laser beam, the soldering position and the size of the solder (S) may be adjusted and discharged accordingly. Furthermore, according to the present invention, the solder (S) continuously discharged in sequence may be maintained under continuous irradiation of the laser beam for a predetermined period of time, thereby improving wettability and enhancing or strengthening the bonding force.

The process in which a plurality of solder balls (S) are discharged to the soldering position as described above will be explained in greater detail below with reference to the drawings.

Meanwhile, in the laser soldering apparatus (100) according to the present invention, the solder (S) may be sequentially transferred from an external transfer means (not shown) to the nozzle unit (111) by gravity or by an auxiliary transfer gas. In this case, the auxiliary transfer gas may supply the solder (S) toward the nozzle unit (111) at an appropriate speed. The solder (S) may be formed in a generally spherical shape and may consist of a metallic alloy that can be melted by laser irradiation or the like. The solder (S) may be used to attach electronic or electrical components to a substrate (not shown). Here, the solder may be made of a single material such as a polymer, glass, metal, or composite material.

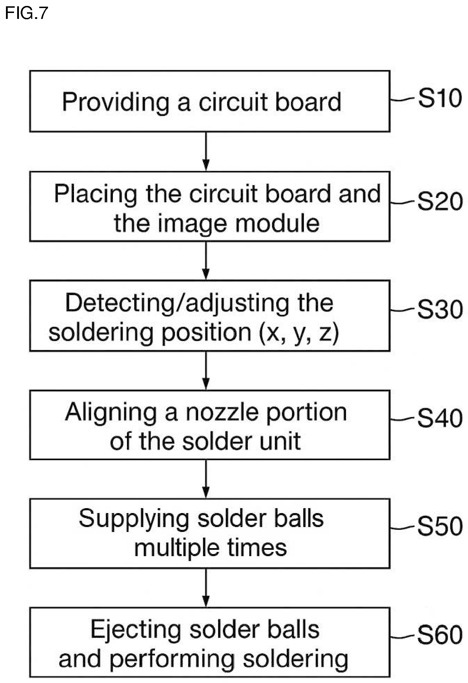

Hereinafter, the soldering process using the laser soldering apparatus (100) having an adjustable soldering position as described above will be explained with reference to FIGS. 7 to 9.

A laser soldering method according to the present invention using the laser soldering apparatus (100) may include: a circuit board preparation step (S10) and a placement step of placing the image module (300) on which the circuit board is mounted; a fixing step (S20) of coupling the image module (300) by inserting the fixing pins (221) of the second fixing block (220) into the insertion holes (211) of the first fixing block (210); a monitoring and adjusting step (S30) of recognizing the x, y, and z coordinates of the center points of the fixing pins (221) of the second fixing block (220), monitoring the positions of the center points of the fixing pins (221) within the insertion holes (211), and, according to the result of the monitoring, aligning the nozzle unit (111) of the soldering unit (110) that supplies the solder (S); a solder supplying step (S50) of supplying the solder (S) to the nozzle unit (111) continuously or intermittently at predetermined time intervals so as to perform multiple soldering operations on the insertion hole portions (211) of the first fixing block (210) into which the fixing pins (221) of the second fixing block (220) are inserted; and a soldering step (S60) of irradiating the solder (S) with the laser beam to melt it, and discharging the solder (S) to the portions of the fixing pins (221) and insertion holes (211) to perform soldering.

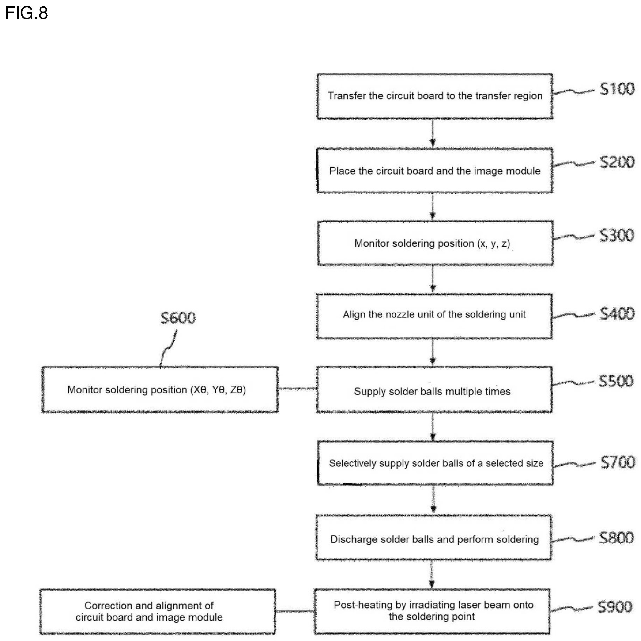

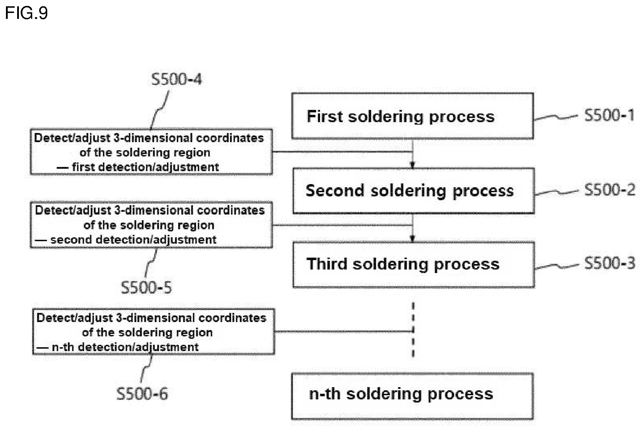

Specifically, referring to FIGS. 8 and 9, the process begins by transferring the image module (300) to the region to be processed in order to couple the image module (300) to the circuit board (S100). At this time, the image module (300) may be provided in a state in which the fixing block (200) is formed and coupled to the circuit board, or the circuit board may be mounted on the image module (300) to form an integrated structure.

Next, the image module (300) is positioned such that the fixing pins (221) of the second fixing block (220) are inserted into the insertion holes (211) of the first fixing block (210) (S200). At this time, three insertion holes (211) of the first fixing block (210) may be formed radially, and the three fixing pins (221) formed on the second fixing block (220) may be respectively inserted into the insertion holes (211) to be stably fixed.

Subsequently, in order to identify the exact soldering position of the fixing pin (221) portion of the second fixing block (220) that is inserted into the insertion hole (211) of the first fixing block (210), the x, y, and z coordinates of the center point of the fixing pin (221) are recognized, and the position of the center point of the fixing pin (221) within the insertion hole (211) is monitored (S300).

Here, the soldering position may be determined according to the distance between the center point of the insertion hole (211) and the center point of the fixing pin (221) inserted into the insertion hole (211) of the first fixing block (210) on a plane. That is, the position where the inner circumferential surface of the insertion hole (211) of the first fixing block (210) and the outer circumferential surface of the fixing pin (221) are in their closest proximity is primarily set as the soldering position, and a region that is at least partially overlapped therewith may be set as an additional soldering position.

Thereafter, while the insertion hole (211) and the fixing pin (221) remain inserted, the nozzle unit (111) of the soldering unit (110) may be aligned according to the above coordinate values (S400). Once the processing point is primarily determined according to the coordinate values, the solder (S) may be continuously supplied to the nozzle unit (111) of the soldering unit (110).

Preferably, as illustrated in FIG. 9, once the coordinate values are set, a first soldering process (P1) is performed (S500-1), followed by a second soldering process (P2) performed in a shape at least partially overlapping with the first soldering (P1) (S500-2), and then a third soldering process (P3) including the overlapping boundary region (B) between the first soldering (P1) and the second soldering (P2) is performed (S500-3). The number of soldering operations (n) is not particularly limited as long as the fixing pins (221) can be stably fixed within the insertion holes (211) without movement; for example, the soldering may be performed within a range of two to seven times. In addition, before and after each of the first soldering (P1), second soldering (P2), and third soldering (P3), a process of detecting the three-dimensional coordinates (x, y, z) according to the area, size, and shape of the processing point may be carried out (S500-4, S500-5, S500-6).

At this time, according to the shape of the solder bump (2) formed as the solder (S) is discharged, the soldering unit (110) may be disposed at a predetermined inclination angle (θ) with respect to the fixing pins (221) and insertion holes (211), and the coordinates X_{θ}, Y_{θ}, and Z_{θ} of the center point of the fixing pin (221) may be recognized and adjusted accordingly (S600). The solder (S) may be supplied intermittently or continuously at predetermined time intervals, and the size of the solder (S) may be adjusted and supplied according to the shape and size of the solder bump (2) formed by soldering at the processing point, thereby enabling an effective soldering process (S700, S800).

Finally, after the second soldering (P2), a post-heating process may be performed (S900) in which the laser beam irradiation is maintained for a predetermined period of time to improve the wettability and processing efficiency of the overlapping region.

The post-heating process may include an alignment correction step for correcting the alignment of the circuit board and the image module. Through the post-heating process, the solder may be remelted, and offsets in the X-axis, Y-axis, Z-axis, X-theta, Y-theta, and Z-theta directions may be set according to the amount of contraction of the solder, thereby correcting the alignment between the circuit board and the image module.

Furthermore, as described above, in addition to the multiple soldering operations, a preheating process for improving wettability may further be included. The preheating process may be performed at one or more of the following time points: before or after the first soldering (P1), before or after the second soldering (P2), and before or after the nth soldering (Pn). For example, after discharging the solder (S) toward the soldering point through the first soldering (P1), before performing the second to nth soldering (P2 to Pn), the spreadability of the solder bump (2) may be reduced by a relatively low-temperature region, leading to soldering defects such as cold joints, cracks, or poor bonding. Here, the term "spreadability" refers to the degree to which the solder bump (2), when placed on the soldering point, spreads such that a larger contact area can be achieved. Accordingly, to prevent degradation of spreadability caused by the temperature of the soldering region maintained at a relatively lower temperature than that of the solder bump (2), the preheating process may additionally be performed.

As shown in FIG. 10, the preheating process may be performed not only by additional laser irradiation from the laser generation unit (20), but also by adjusting the height of the head portion (51) so that it is displaced from the laser focus, thereby forming a separation distance between the laser focal point and the soldering point. In other words, the head portion (51) may selectively adjust a focusing distance (F) and a defocusing distance (DF) from the soldering point, representing the state in which preheating and heating can be performed through the laser.

When the soldering point is located at the focusing distance (F), the laser output is concentrated, and thus the metal soldering point may melt or be thermally damaged. Therefore, irradiation of the laser at the focusing distance (F) is suitable for melting the solder bump (2) itself.

In contrast, when the soldering point is located at the defocusing distance (DF), the laser output is dispersed and the irradiation area increases; hence, the defocusing distance (DF) may be used when heating a wider area. Accordingly, irradiating the laser at the defocusing distance (DF) serves to minimize the temperature difference between the solder bump (2) and the soldering point, thereby improving wettability and increasing the bonding area.

The soldering point positioned at the defocusing distance (DF) as described above may thus be preheated. The solder bump (2) may be located within the area being preheated. More specifically, the solder bump (2)-that is, the region to be bonded, including the periphery surrounding the bonding site-may serve as a preheating region (not shown).

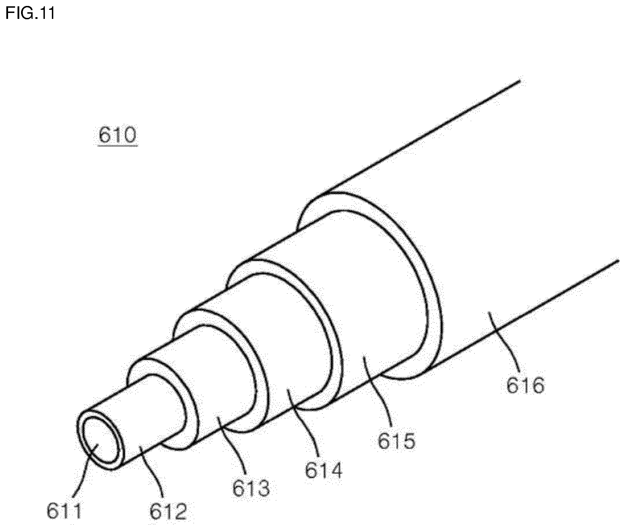

FIG. 11 is a diagram illustrating the configuration of an optical fiber (610) for transmitting a laser according to an embodiment of the present invention.

Referring to FIG. 11, the laser delivered to the head portion (230) of the multilaser soldering apparatus (100) according to the present invention may be an optical fiber laser (FL) or a diode laser transmitted through the optical fiber (610). The optical fiber (610) may include a core (611) through which the laser beam is transmitted, and one or more claddings (612, 613, 614, 615, 616) surrounding the core (611). Specifically, the core (611) may be configured to transmit the laser by total internal reflection or the like, and the claddings (612, 613, 614, 615, 616) may serve to protect the core (611) from exposure or external impact, thereby performing a shock-absorbing and protective function. For example, the plurality of claddings (612, 613, 614, 615, 616) may include materials such as polyvinyl chloride (PVC) for shock absorption, aramid yarn for enhanced durability, polyimide, or silicone.

In addition, the shape of the core (611) located inside the claddings (612, 613, 614, 615, 616) may vary.The core may be formed in various shapes, such as rectangular, polygonal, or circular. Depending on the size and shape of the core, the size and quality of the laser beam may vary accordingly.

Furthermore, the apparatus or method according to an embodiment of the present invention may include the following configurations. The inspection described below may include a first inspection (pre-inspection) and a second inspection (post-inspection) performed by an inspection unit.In the first inspection (pre-inspection), the alignment state and the soldering positions are detected before soldering is performed. In the second inspection (post-inspection), which is conducted after soldering has been performed, the soldering unit (110) is inspected for defects such as open circuits, shorts, cracks, voids, excess solder, bridge contamination, insufficient solder, cold joints, poor wettability, overheating, corrosion, erosion, component misalignment, gaps between components, and unsoldered areas, among others. As described below, an object that fails to satisfy the quality standards according to the results of the second inspection may be classified separately from an object that meets the quality standards, and reworking (resoldering or rework) may be performed on the object that fails to meet the quality standards.

First, the laser supplied from the laser supply device may be a laser having a wavelength with a high absorption rate depending on the material of the solder. In addition, the laser may be a solid-state laser, such as a fiber laser or a diode laser (Fiber Laser or Diode Laser). The laser beam generated from the laser generation device may be transmitted to the laser soldering head through the optical fiber, without requiring a separate optical mirror. Accordingly, stable supply of the laser and precise operation during soldering by laser irradiation can be achieved.

Second, the laser processing apparatus may include a pick-and-place soldering head or a jet soldering head that includes a laser soldering nozzle. The laser soldering head may include an optical focusing head for the laser beam, a solder (S) supply device, and the nozzle. Here, the term "laser soldering head" refers to the head portion, and it may be configured as a single head, or as a dual head including two heads. Of course, it may also be configured as a multi-head structure including three or more heads. By including two or more laser soldering heads, the productivity of the apparatus can be significantly increased.

Third, a vision inspection module (unit) or a vision inspection step may be included. By including such a vision inspection module or step, pre-inspection can be performed for checking the position of the camera module to be soldered, its alignment state, and the soldering position. If necessary, post-inspection may also be performed to inspect the soldering quality after the soldering process. Accordingly, (1) a vision inspection module comprising low-magnification and high-magnification lenses may be mounted, or (2) a motorized variable zoom lens (1 × to ×18, and the maximum magnification may be further increased depending on the zoom lens design) may be mounted, enabling automatic inspection from low to high magnification and from a wide area to a narrow area. Although both pre-inspection and post-inspection can be performed using a single vision inspection module, the system may alternatively be configured with separate vision inspection modules to improve productivity - for example, one module for pre-inspection and another module for post-inspection.

When both the pre-inspection and post-inspection are provided by a single vision inspection module, the object that has undergone the pre-inspection may be moved to the soldering position, soldered, and then returned to its previous position for post-inspection. When two vision inspection modules are provided - that is, one for the pre-inspection function and another for the post-inspection function - the object may sequentially move through the modules in the following order: the pre-inspection module, the laser soldering module, and the post-inspection module, such that inspection and soldering are performed successively in sequence.

Furthermore, the apparatus may further include an infrared (IR) inspection device or a three-dimensional (3D) inspection device for performing post-inspection, in order to monitor the soldering quality in real time, to control soldering parameters, and to detect defects such as open circuits, shorts, cracks, voids, excess solder, bridge contamination, insufficient solder, cold joints, poor wettability, overheating, corrosion, erosion, component misalignment, gaps between components, and unsoldered areas.

Fourth, after the post-inspection, the apparatus may further include a sorting device for classifying objects that do not satisfy the required soldering quality standards.

Fifth, after the post-inspection, the apparatus may further include a repair device capable of repairing objects that do not satisfy the required soldering quality standards. The repair device may reirradiate the laser to remelt the solder portion, thereby improving the solder wettability, or may remove the pre-soldered solder and perform resoldering (rework). When removing pre-soldered solder, the system may automatically remove the solder using a mechanical tool such as a pin, or may remelt the solder using the laser and suction it out automatically.

Sixth, for quality control after soldering, the apparatus may further include a cleaning device comprising a dust collection unit for removing dust and foreign substances. The cleaning device may include one or more of the following: a dry air blowing device, a carbon dioxide (CO₂) snow cleaning device, a plasma cleaning device, a laser cleaning device, or an inert gas blowing device.

Seventh, the apparatus may further include a pre-soldering unit that performs preliminary soldering according to the type of substrate to be soldered. In addition, an additional laser soldering head may be provided to enhance soldering quality and maximize productivity.

It will be understood by those skilled in the art to which the present invention pertains that the invention can be embodied in other specific forms without departing from the spirit or essential characteristics thereof. Accordingly, the above-described embodiments are to be considered in all respects as illustrative rather than restrictive. The scope of the invention is defined by the appended claims, rather than by the foregoing description, and all modifications or variations derived from the meaning and range of equivalence of the claims are to be construed as being included within the scope of the present invention.

**LIST OF REFERENCE SIGNS**

| | | | |
|---|---|---|---|
| 1: | Transfer Unit | 2: | Solder Bump |
| 10: | Controller | 20: | Laser Generation Unit |
| 30: | Beam Conversion Unit | 50: | Beam Adjustment Unit |
| 100: | Laser Soldering Apparatus | 110: | Solder Unit |
| 111: | Nozzle Unit | 200: | Fixing Block |
| 210: | First Fixing Block | 211: | Insertion Hole |
| 220: | Second Fixing Block | 221: | Fixing Pin |
| 300: | Image Module | 310: | Thermal Distribution Measuring Unit |
| 350: | Monitoring Unit | C: | Center Line of Nozzle Unit |
| P₁: | First Soldering Spot | P₂: | Second Soldering Spot |
| P₃: | Third Soldering Spot | Pₙ: | n-th Soldering Spot |
| S: | Solder / Solder Ball | W: | Optical Fiber |

## Claims

1. A laser soldering apparatus comprising:
a controller;
a fixing block which is coupled to a circuit board and comprises a plurality of fixing pins extending in one direction and a plurality of insertion holes into which the fixing pins are inserted;
an image module coupled to the circuit board through the fixing block;
a laser generation unit for generating a laser beam;
a solder unit which is operated to be movable under control of the controller to perform soldering of the insertion hole region into which the fixing pins are inserted a plurality of times at predetermined time intervals, the solder unit including at least one nozzle unit configured to receive solder and discharge the molten solder; and
a monitoring unit disposed at one side of the solder unit to monitor a distribution range of the solder supplied by irradiation of the laser beam,
wherein a solder feeding position of the solder supplied from the solder unit to the region of the fixing pins and the insertion holes is adjusted according to the monitoring result of the monitoring unit.

2. The laser soldering apparatus according to claim 1,
wherein the solder is provided as one or more solder balls, and the laser beam is irradiated onto the one or more solder balls to melt and discharge the same.

3. The laser soldering apparatus according to claim 1,
wherein the nozzle unit is provided as a sleeve that may be heated by the laser, and
the solder is melted by heat from the sleeve heated by the laser.

4. The laser soldering apparatus according to claim 2,
wherein the one or more solder balls are supplied to the regions of the fixing pins and
insertion holes at predetermined time intervals in a range of two to seven times.

5. The laser soldering apparatus according to claim 1,
wherein the solder is controlled to be supplied and soldered starting from a position where an outer circumferential surface of the fixing pin and an inner circumferential surface of the insertion hole are in contact or in closest proximity to each other.

6. The laser soldering apparatus according to claim 2,
wherein the solder unit is inclined at a predetermined angle with respect to the fixing pins and the insertion holes, and is configured to discharge the solder balls in such an inclined arrangement.

7. The laser soldering apparatus according to claim 1,
wherein the laser beam is controlled so that irradiation continues for a predetermined period of time on the molten and discharged solder.

8. The laser soldering apparatus according to claim 1,
wherein the fixing holes of the fixing block are arranged in three or more positions.

9. The laser soldering apparatus according to claim 2,
wherein a gas supply unit is provided at one side of the solder unit to supply an inert gas to the discharged solder balls.

10. The laser soldering apparatus according to claim 2,
wherein the solder supplied to the nozzle unit comprises a structure in which a size of the solder is controlled by the controller according to a distribution range of the solder detected during the soldering process.

11. The laser soldering apparatus according to claim 1 further comprising a beam control unit configured to adjust an irradiation position of the laser beam,
wherein the beam control unit comprises:
a beam focusing unit configured to adjust a focal position of the laser beam; and
a laser irradiation unit configured to obtain information on the position and alignment state at which the laser beam adjusted by the beam focusing unit is to be irradiated,
and to irradiate the laser beam onto a workpiece.

12. The laser soldering apparatus according to claim 1,
wherein the solder unit further comprises at least one beam conversion device configured to adjust an output area of the laser beam.

13. The laser soldering apparatus according to claim 1,
wherein the laser beam emitted from the solder unit includes a plurality of wavelengths, and each wavelength is transmitted to heterogeneous or homogeneous workpieces to perform joining.

14. The laser soldering apparatus according to claim 1,
wherein delivery of the laser beam is performed through an optical fiber to a head unit, and a laser irradiation position is aligned.

15. The laser soldering apparatus according to claim 14,
wherein a core of the optical fiber comprises a structure formed in a circular or polygonal shape, and the laser irradiation position is aligned.

16. The laser soldering apparatus according to claim 1,
wherein the fixing block is pre-joined and transported by a transfer unit, such that a laser irradiation position and a solder discharge position are aligned.

17. The laser soldering apparatus according to claim 16,
wherein the solder unit further comprises an imaging unit configured to perform image processing of a soldering position.

18. The laser soldering apparatus according to claim 1,
wherein the laser is irradiated in a flat-top type output form, and the laser irradiation position is aligned, in the laser soldering apparatus comprising an adjustable soldering position.

19. A laser soldering apparatus with an adjustable soldering position, comprising:
a controller;
an image module coupled to a circuit board;
a first fixing block formed on one side of the image module and comprising a plurality of fixing pins extending in one direction;
a second fixing block provided to fix the image module onto the board, the second fixing block being in surface contact with the first fixing block of the image module and
comprising a plurality of insertion holes into which the fixing pins are inserted;
a laser generation unit configured to generate a laser beam;
a solder unit operated to be movable under the control of the controller to perform soldering of the insertion-hole region into which the fixing pins are inserted at predetermined time intervals, the solder unit including at least one nozzle unit configured to accommodate solder and discharge molten solder; and
a monitoring unit disposed at one side of the solder unit and configured to monitor a distribution range of solder balls supplied by irradiation of the laser beam,
wherein a supply position of the solder balls discharged from the solder unit into the fixing-pin and insertion-hole region is adjusted according to monitoring results of the monitoring unit.

20. A laser soldering apparatus with an adjustable soldering position, comprising:
a controller;
an image module coupled to a circuit board comprising a plurality of insertion holes,
the image module including a plurality of fixing pins formed to extend in one direction so as to be inserted into the insertion holes;
a laser generation unit configured to generate a laser beam;
a solder unit operated to be movable under the control of the controller to perform multiple soldering operations on an insertion-hole region into which the fixing pins are inserted at predetermined time intervals, the solder unit including at least one nozzle unit configured to accommodate solder and discharge molten solder; and
a monitoring unit disposed at one side of the solder unit and configured to monitor a distribution range of solder balls supplied by irradiation of the laser beam,
wherein a supply position of the solder balls discharged from the solder unit into the fixing-pin and insertion-hole region is adjusted according to monitoring results of the monitoring unit.

21. A laser soldering method using a laser soldering apparatus comprising an adjustable soldering position, the method comprising:
placing an image module mounted on a circuit board;
a fixing step of positioning fixing pins of the image module into insertion holes of a fixing block;
a monitoring step of recognizing x, y, and z coordinates of a center point of the fixing pins and monitoring a position of the center point of the fixing pins within the insertion holes;
an adjusting step of aligning a nozzle unit of a solder unit supplying solder according to monitoring results;
a supplying step of supplying solder continuously or intermittently at predetermined time intervals through the nozzle unit to perform multiple soldering operations on the insertion-hole region into which the fixing pins are inserted; and
a discharging step of irradiating the solder with a laser beam to melt the solder and
injecting the molten solder into the fixing-pin and insertion-hole region.

22. The laser soldering method according to claim 21,
wherein, in the discharging step, the laser beam is maintained to be irradiated for a predetermined time after the solder is discharged.

23. The laser soldering method according to claim 21,
wherein the discharging step comprises:
a first soldering process in which the solder is supplied to a position where an outer circumferential surface of a fixing pin and an inner circumferential surface of an insertion hole are in contact or in closest proximity;
a second soldering process in which the solder is supplied in a shape that at least partially overlaps with the first soldering region; and
a third soldering process in which the solder is discharged to at least a portion of the overlapping region.

24. The laser soldering method according to claim 23,
wherein, after the second soldering process, the solder unit is adjusted at a predetermined angle according to X_{θ}, Y_{θ}, and Z_{θ} coordinates corresponding to a three-dimensional shape of the overlapping region.

25. The laser soldering method according to claim 21,
further comprising a step of setting the size of the supplied solder to be selectively adjusted according to a distribution range of the solder detected during the soldering process in the step of providing the solder to the nozzle unit.

26. The laser soldering method according to claim 21,
wherein, in the second soldering process or the third soldering process, a post-heating process is included in which the irradiation of the laser beam is maintained for a predetermined time on the overlapping region.

27. The laser soldering method according to claim 21,
wherein the step of supplying solder to the nozzle unit is performed in a range of at least two to seven times.

28. The laser soldering method according to claim 21,
wherein, after the discharging step, with respect to the fixing pin and the insertion hole, the solder unit is arranged at a predetermined inclination angle (θ), and a process of recognizing X₀, Y₀, and Z₀ coordinates corresponding to a center point of the fixing pin is performed.

29. The laser soldering method according to claim 21,
wherein, in the step of supplying solder to the nozzle unit, an inert gas discharged from a gas supply unit formed at one side of the solder unit is provided to the discharged solder.

30. The laser soldering method according to claim 29,
wherein the process of supplying the inert gas is performed simultaneously or alternately in conjunction with the irradiation process of the laser beam for melting the solder.

31. The laser soldering method according to claim 26,
wherein the post-heating process includes a correction alignment step of re-melting the solder and setting offsets in the x-axis, y-axis, z-axis, x-theta, y-theta, and z-theta directions according to a shrinkage amount of the solder, thereby correcting the alignment between the circuit board and the image module.
